# EUROPÄISCHE PATENTSCHRIFT

(11) **EP 1 258 181 B1**
(45) Veröffentlichungstag und Bekanntmachung des Hinweises auf die Patenterteilung: **06.10.2004**
(21) Anmeldenummer: 01915256.0
(22) Anmeldetag: 15.02.2001
(51) Int. Cl.: H05K 5/06

(54) **VORRICHTUNG ZUR AUFNAHME ELEKTRISCHER ODER ELEKTRONISCHER KOMPONENTEN**
DEVICE FOR ACCOMMODATING ELECTRIC OR ELECTRONIC COMPONENTS
DISPOSITIF POUR LOGER DES COMPOSANTS ELECTRIQUES OU ELECTRONIQUES

(30) Priorität: 24.02.2000 DE 10008695
(43) Veröffentlichungstag der Anmeldung: 20.11.2002
(73) Patentinhaber: Henkel Kommanditgesellschaft auf Aktien, 40191 Düsseldorf (DE)
(72) Erfinder: MÜNDELEIN, Olaf, 58644 Iserlohn (DE)
(74) Vertreter: Mathes, Nikolaus, Dr.
(86) Internationale Anmeldenummer: PCT/EP2001/001666
(87) Internationale Veröffentlichungsnummer: WO 2001/063995

(56) Entgegenhaltungen:
- EP-A- 0 482 419
- DE-A- 3 315 230
- GB-A- 1 587 998

## Beschreibung

Die Erfindung betrifft eine Vorrichtung zur Aufnahme von wenigstens einer elektrischen oder elektronischen Komponente mit einem Gehäuse, in dessen Inneren die wenigstens eine Komponente angeordnet ist, wobei das Innere des Gehäuses mit einem Vergussmaterial ausgefüllt ist.

Zur Herstellung von Formteilen, zum Abdichten von Steckverbindern oder als Vergussmasse für elektrische oder elektronische Komponenten ist es bekannt, Schmelzklebstoffe zu verwenden. So werden Schmelzklebstoffe beispielsweise seit Jahren für wasserdichte Steckverbinder eingesetzt. Darüber hinaus gibt es auch spezielle Schmelzklebstoffe auf Polyamidbasis (z.B. das von der Anmelderin vertriebene Produkt Macromelt®), die mehr als nur eine wasserdichte Verklebung bereitstellen. Ein solcher Klebstoff verhindert nämlich nicht nur das Eindringen von Feuchtigkeit in den Stecker, sondern gibt dem Steckverbinder auch mechanische Festigkeit und erfüllt noch andere Aufgaben, die bisher von zusätzlichen kostenintensiven Kunststoffteilen erfüllt wurden. Die Schmelzklebstoffe dieser Art basieren z.B. auf Polyamid und weisen einen Schmelzbereich von 120 bis 180 °C auf. Sie haften auf vielen Kunststoffen, wie Polyethylen, Polyvinylchlorid sowie Polyamid und sind niedrig viskos. In einem dem Spritzguss verwandten Verfahren wird der erhitzte Schmelzklebstoff in ein Werkzeug gespritzt. Die dünnflüssige Schmelze ist geeignet, auch ohne hohen Druck filigrane Bauteile zu umfließen, ohne die Funktion der Bauteile zu beeinträchtigen. Schon bei einem Druck zwischen 5 und 10 bar gelangt der Klebstoff in engste Zwischenräume. Der niedrige Druck hat zur Folge, dass das gesamte Verfahren sehr wirtschaftlich ist, da die Maschine auf diese geringe Belastung ausgelegt werden kann. Die Werkzeuge können preisgünstig aus Aluminium hergestellt werden. Diese Verfahren eignen sich beispielsweise zum Vergießen von Kabeldurchführungen oder zur Aderisolierung. Der Verguss von Schaltern, Steckern, Kontakten, Sensoren und anderen elektronischen Bauelementen ist ebenfalls möglich und eröffnet ein weiteres Einsatzgebiet. Überall dort, wo elektrische Ströme fließen und eine Abdichtung notwendig ist, lässt sich ein solches Verfahren einsetzen.

Grundsätzlich ist es möglich, entweder ein Gehäuse, in dem die elektronische Komponente angeordnet ist, mit dem Schmelzklebstoff auszugießen oder das gesamte Gehäuse selbst aus Schmelzklebstoff herzustellen. Ein solches nur aus Schmelzklebstoff bestehendes Gehäuse weist aber verglichen mit einem Kunststoffgehäuse nur eine geringe mechanische Festigkeit auf und kann deshalb nur in bestimmten Einsatzfällen verwendet werden.

Bei der Verwendung von gattungsgemäßen Vorrichtungen mit einem Kunststoffgehäuse und einer inneren Füllung aus Vergussmaterial aus Schmelzklebstoff tritt jedoch das Problem auf, dass bei Temperaturwechsel der fertigen Bauteile sich der Schmelzklebstoff wieder von der Gehäusewand löst, so dass das oder die elektronischen Bauelemente im Gehäuse nicht mehr abgedichtet sind. Aus diesem Grunde ist es bisher üblich, das Gehäuse vollständig von außen mit Schmelzklebstoff zu umspritzen. Dies ist aus Platzgründen jedoch nicht immer möglich.

Eine Vorrichtung mit den im ersten Teil des Anspruchs genannten Merkmalen ist aus EP-A-0 482 419 bekannt.

Aufgabe der Erfindung ist es deshalb, eine gattungsgemäße Vorrichtung bei Beibehaltung ihrer mechanischen Festigkeit so weiterzuentwickeln, dass sie auch bei Temperaturwechseln nach außen zuverlässig dicht ist.

Diese Aufgabe wird mit einer Vorrichtung der eingangs bezeichneten Art mit den in Anspruch 1 definierten Merkmalen gelöst.

Beim Ausgießen des mit wenigstens einem elektronischen Bauelement oder dergl. ausgestatteten Gehäuses mit Vergussmaterial fließt das Vergussmaterial dann auch in den Bereich zwischen der Gehäuseinnenwand und dem umlaufenden Vorsprung und ist dadurch sozusagen am Gehäuse selbst arretiert. Selbst bei Temperaturwechseltests, d.h. krassen Temperaturwechseln, ist dann sicher gewährleistet, dass sich das Vergussmaterial nicht von der Gehäuseinnenwand lösen kann, so dass die Vorrichtung insgesamt zuverlässig dicht bleibt.

Dabei ist dann vorzugsweise vorgesehen, dass der Vorsprung im mittleren Bereich des Gehäuses angeordnet ist, so dass die Vergussmasse dann in etwa symmetrisch im Gehäuse gehalten ist.

Wie an sich bekannt, ist besonders vorteilhaft vorgesehen, dass das Vergussmaterial aus Schmelzklebstoff auf Polyamidbasis besteht. Hierbei kann vorzugsweise ein Klebstoff eingesetzt werden, der von der Anmelderin unter der Bezeichnung Macromelt® in den Verkehr gebracht wird. Alternativ können auch andere Schmelzklebstoffe, z.B. auf Polyurethan- oder Polyesterbasis, vorteilhaft verwendet werden.

Wenn das Gehäuse mit dem Vergussmaterial ausgespritzt werden soll, ist vorteilhaft vorgesehen, dass das Gehäuse im Bereich des Vorsprunges wenigstens eine Anspritzbohrung für das Vergussmaterial aufweist. Die Anspritzbohrung durchdringt dann den Vorsprung, welcher ansonsten jedoch umlaufend ausgebildet ist.

Der Vorsprung ist stabil mit der Außenwand des Gehäuses verbunden, wenn der Vorsprung umlaufend durchgehend mittels einer stegförmigen Verbindungswand mit der Außenwand des Gehäuses verbunden ist. Bevorzugt ist hierbei dann weiterhin vorgesehen, dass Vorsprung und Verbindungswand zusammen querschnittlich T-förmig ausgebildet sind.

Bei einer besonders bevorzugten Weiterbildung sieht die Erfindung weiterhin vor, dass der Vorsprung umlaufend abschnittsweise mittels jeweils einer Verbindungswand mit der Außenwand des Gehäuses verbunden ist. Dies ermöglicht ein besonders gutes Einfließen des Verbundmateriales in den Spalt zwischen Vorsprung und Außenwand und verhindert eine Blasenbildung im Bereich hinter der Hinterschneidung des Vorsprunges. Auch ermöglicht dies die Herstellung des Gehäuses der erfindungsgemäßen Vorrichtung im Kunststoffspritzgussverfahren mit gleichmäßigen Wandstärken ohne Schrumpflochgefahr in der innenseitigen Oberfläche des Gehäuses.

Besonders zweckmäßig ist es bei dieser Ausführungsform schließlich, wenn die Verbindungswand abschnittsweise jeweils kreisförmig ausgebildet ist, wie dies die Erfindung ebenfalls vorsieht.

Die Erfindung ist nachstehend anhand der Zeichnung beispielhaft näher erläutert. Diese zeigt in:
- Fig. 1: einen Querschnitt einer erfindungsgemäßen Vorrichtung,
- Fig. 2: die Vorrichtung nach Fig. 1 mit Hervorhebung des abgedichteten Innenbereiches,
- Fig. 3: einen Querschnitt durch eine abgewandelte Ausführungsform,
- Fig. 4: eine Seitenansicht auf die Ausführungsform nach Fig. 2,
- Fig. 5: einen Querschnitt durch eine dritte Ausführungsform,
- Fig. 6: eine Draufsicht der Ausführungsform nach Fig. 5 und in
- Fig. 7: eine Seitenansicht der Ausführungsform nach Fig.5 und 6.

Nachfolgend sind gleiche oder analoge Elemente oder Bauteile der verschiedenen Ausführungsformen jeweils mit denselben Bezugszeichen versehen.

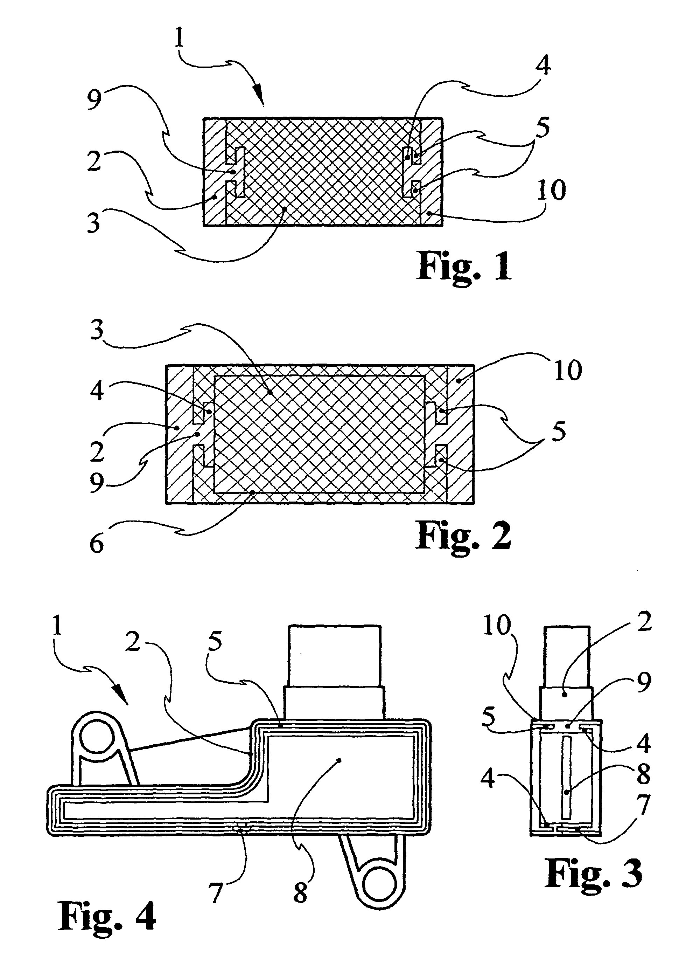

Eine erfindungsgemäße Vorrichtung ist in Figur 1 allgemein mit 1 bezeichnet. Diese Vorrichtung 1 weist bei diesem Ausführungsbeispiel ein rohrförmiges Gehäuse 2, beispielsweise aus Kunststoff, auf und dient zur dichten Aufnahme einer andeutungsweise dargestellten elektronischen Komponente 8. Nach der Anordnung dieser elektronischen Komponente 8 im Gehäuse 2 wird das Gehäuse 2 im Inneren mit einem Vergussmaterial 3, vorzugsweise aus einem Schmelzklebstoff auf Polyamidbasis, ausgegossen. Beispielsweise handelt es sich dabei um den als Macromelt® bekannten Klebstoff.

Um zu gewährleisten, dass das Innere des Gehäuses 2 auch bei Temperaturschwankungen oder insbesondere bei Temperaturwechseltests dicht bleibt, ist das Gehäuse 2 innenseitig mit wenigstens einem umlaufenden, einen Hinterschnitt aufweisenden Vorsprung 4 versehen. Dieser Vorsprung 4 ist vorzugsweise, wie bei den ersten beiden Ausführungsbeispielen ausgeführt, T-förmig ausgebildet und bevorzugt im mittleren Bereich des Gehäuses 2 angeordnet. Der Vorsprung 4 ist über eine ebenfalls umlaufend ausgebildete, stegförmige Verbindungswand 9 mit der Außenwand 10 des Gehäuses 2 durchgehend fest verbunden, vorzugsweise einteilig mittels Kunststoffspritzgussverfahren hergestellt.

Aufgrund dieser Gestaltung fließt in die Vorrichtung 1 flüssig, ggf. unter leicht erhöhtem Druck, eingegebenes Vergussmaterial auch in die Zwischenräume 5 zwischen dem Vorsprung 4 und der innenseitigen Wandfläche des Gehäuses 2. Das Vergussmaterial 3 härtet auch hier aus, so dass das Vergussmaterial 3 in diesen Zwischenräumen 5 sozusagen arretiert ist. Dehnen sich nun bei Temperaturwechseln das Gehäuse 2 und das Vergussmaterial 3 unterschiedlich aus, so ist trotzdem, da das Vergussmaterial durch die Arretierung in den Zwischenräumen 5 festgehalten ist, gewährleistet, dass die Vorrichtung 1 nach außen dicht bleibt. Dieser dichte Bereich ist in Figur 2 mit einem Rechteck 6 angedeutet, im Bereich dieses Rechteckes 6 steht ein zuverlässig dichter Bereich innerhalb der Vorrichtung 1 zur Verfügung, in dem elektronischen Bauteile durch Umgießen mit Schmelzklebstoff sicher abgedichtet angeordnet werden können.

In den Figuren 3 und 4 ist eine weitere Ausführungsform einer erfindungsgemäßen Vorrichtung dargestellt. Die wiederum mit 1 bezeichnete Vorrichtung weist hier ein anders gestaltetes Gehäuse 2 auf. Wie bei der Ausführungsform nach Figuren 1 und 2 ist das Gehäuse 2 innenseitig mit einem umlaufenden T-förmigen Vorsprung 4 versehen. Um bei einem derart gestalteten Gehäuse 2 ein Anspritzen des Vergussmaterials zu ermöglichen, ist vorgesehen, dass das Gehäuse 2 im Bereich des Vorsprunges 4 wenigstens eine Anspritzbohrung 7 für das Vergussmaterial 3 aufweist. Abgesehen von dieser Anspritzbohrung 7 ist der Vorsprung 4 jedoch unversehrt umlaufend ausgebildet, um die Dichtfunktion zu gewährleisten.

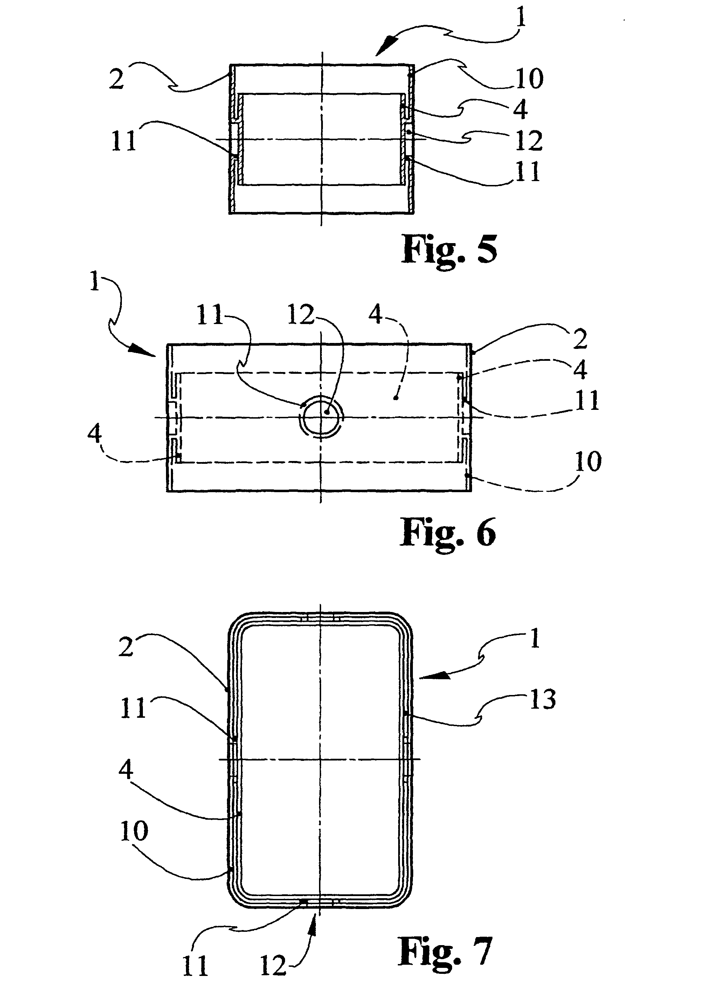

Bei dem ohne eingefülltes Vergussmaterial und ohne ein elektronisches Bauteil dargestellten Ausführungsbeispiel nach den Figuren 5 bis 7 ist die den umlaufenden Vorsprung 4 mit der Außenwand 10 verbindende Verbindungswand 11 nur abschnittsweise und als ring- bzw. kreisförmige Verbindungswand 11 ausgebildet. Insgesamt weist die Vorrichtung 1 in der Ausführungsform nach den Figuren 5 bis 7 vier Abschnitte mit jeweils kreisförmig angeordneten Verbindungswänden 11 auf. Von der Außenseite her betrachtet werden in diesen Abschnitten vier napfartige Vertiefungen 12 in der Außenwand 10 des Gehäuses 2 ausgebildet. Es ist aber auch möglich, diese Bereiche vollflächig auszubilden und damit die äußere Oberfläche des Gehäuses 2 glatt bzw. vertiefungsfrei auszugestalten. Dadurch, dass die Verbindungswand 11 umlaufend nur noch abschnittsweise und nicht mehr durchgehend wie bei den Ausführungsbeispielen nach den Figuren 1 bis 4 ausgebildet ist, ergibt sich bis auf die Bereiche der Verbindungswände 11 ein im wesentlichen offener, umlaufender Spalt 13 zwischen der Innenseite der umlaufenden Außenwand 10 und dem umlaufenden Vorsprung 4 des Gehäuses 2, der außerhalb der ringförmigen Wandbereiche 11 auch in Blickrichtung der Draufsicht nach Fig. 7 offen ist. Bei den Ausführungsbeispielen nach den Fig. 1 bis 4 ist demgegenüber die Verbindungswand 9 mit parallelem Verlauf durchgehend zwischen Vorsprung 4 und Außenwand 10 ausgebildet, so dass in Blickrichtung der Seitenansicht nach Fig. 4 die spaltförmigen Zwischenräume 5 mittels der Verbindungswand 9 von einander getrennt und somit geschlossen ausgebildet sind. Beim Vergießen des Vergussmateriales 3 ist bei diesen Ausführungsbeispielen dessen unmittelbarer Durchfluss innerhalb dieser spaltförmigen Öffnung vom Zwischenraum 5 einer Seite zum Zwischenraum 5 der anderen Seite nicht möglich. Demgegenüber kann beim Vergießen des Vergussmateriales 3 in die Vorrichtung 1 gemäß Ausführungsbeispiel nach Fig. 5 bis 7 dieses nun im wesentlichen ungehindert in den (nun nicht mehr durch eine Trennwand in zwei Zwischenräume getrennten) Spalt 13 einfließen und den Vorsprung 4 hintergreifen. Im Spalt 13 befindliche Luft kann beim Einfließen des Vergussmateriales, ohne von einer Verbindungswand des Vorsprunges 4 zur Außenwand 10 behindert zu werden, frei und ungehindert entweichen. Die Gefahr von eingeschlossenen Luftbläschen besteht dadurch nicht mehr.

Natürlich ist die Erfindung nicht auf die dargestellten Ausführungsbeispiele beschränkt. Weitere Ausgestaltungen sind möglich, ohne den Grundgedanken zu verlassen. So können bei größeren Gehäusen 2 auch mehrere, in Richtung auf das Zentrum der Vorrichtung 1 aufeinanderfolgende Vorsprünge 4 vorgesehen sein. Auch ist die Anzahl an kreisförmigen Verbindungswänden 11 an den jeweiligen Verwendungszweck der Vorrichtung 1 anpassbar. Natürlich kann die Verbindungswand 11 auch jeden beliebigen anderen geometrischen Verlauf aufweisen, insbesondere aber auch als Vollzylinder und somit als stabförmige Verbindung zwischen Außenwand 10 und Vorsprung 4 ausgebildet sein.

## Patentansprüche

1. Vorrichtung (1) zur Aufnahme wenigstens einer elektrischen oder elektronischen Komponente (8) mit einem Gehäuse (2), in dessen mit einem Vergussmaterial (3) ausgefüllten Inneren die wenigstens eine Komponente (8) angeordnet ist, wobei das Gehäuse (2) innenseitig mit wenigstens einem umlaufenden, einen Hinterschnitt aufweisenden Vorsprung (4) versehen ist,
**dadurch gekennzeichnet,**
**dass** zwischen der Innenseite einer umlaufenden Außenwand (10) und dem wenigstens einen umlaufenden Vorsprung (4) des Gehäuses (2) ein umlaufender Spalt (13) oder ein umlaufender spaltförmiger Zwischenraum (5) ausgebildet ist, und das Vergussmaterial aus Schmelzklebstoff besteht.

2. Vorrichtung nach Anspruch 1,
**dadurch gekennzeichnet,**
**dass** der Vorsprung (4) im mittleren Bereich des Gehäuses (2) angeordnet ist.

3. Vorrichtung nach Anspruch 1 oder 2,
**dadurch gekennzeichnet,**
**dass** das Vergussmaterial (3) aus Schmelzklebstoff auf Polyamidbasis besteht.

4. Vorrichtung nach einem der vorangehenden Ansprüche,
**dadurch gekennzeichnet,**
**dass** das Gehäuse (2) im Bereich des Vorsprunges (4) wenigstens eine Anspritzbohrung (7) für das Vergussmaterial aufweist.

5. Vorrichtung nach einem der vorangehenden Ansprüche,
**dadurch gekennzeichnet,**
**dass** der Vorsprung (4) umlaufend durchgehend mittels einer stegförmigen Verbindungswand (9) mit der Außenwand (10) des Gehäuses (2) verbunden ist.

6. Vorrichtung nach Anspruch 5,
**dadurch gekennzeichnet,**
**dass** Vorsprung (4) und Verbindungswand (9) zusammen querschnittlich T-förmig ausgebildet sind.

7. Vorrichtung nach einem der Ansprüche 1 - 4,
**dadurch gekennzeichnet,**
**dass** der Vorsprung (4) umlaufend abschnittsweise mittels jeweils einer Verbindungswand (11) mit der Außenwand (10) des Gehäuses (2) verbunden ist.

8. Vorrichtung nach Anspruch 7,
**dadurch gekennzeichnet,**
**dass** die Verbindungswand (11) abschnittsweise jeweils kreisförmig ausgebildet ist.

## Claims

1. A Device (1) for accommodating at least one electrical or electronic component (8), comprising a housing (2), in the interior of which the at least one component (8) is arranged, the interior of the housing (2) being filled with a casting material (3) whereby the housing (2) is provided at the inner side with at least one encircling projection (4) having an undercut, **characterised in that** an encircling gap 13 or an encircling gap-like spaces 5 is formed between the inner side of an encircling wall 10 and the encircling projection 4 of the housing 2 and the casting material consists of a hot melt adhesive.

2. Device according to claim 1, **characterised in that** the projection (4) is arranged in the centre region of the housing (2).

3. Device according to claim 1 or 2, **characterised in that** the casting material (3) consists of a hot-melt adhesive on a polyamide base.

4. Device according to any one of the preceding claims, **characterised in that** the housing (2) has in the region of the projection (4) at least one injection bore (7) for the casting material.

5. Device according to any one of the preceding claims, **characterised in that** the projection (4) is continuously encircling and is connected with the outer wall (10) of the housing (2) by means of a web-like connecting wall (9).

6. Device according to claim 5, **characterised in that** the projection (4) and connecting wall (9) are together formed to be cross-sectionally T-shaped.

7. Device according to any one of claims 1 to 4, **characterised in that** the projection (4) encircles in sections and is connected with the outer wall (10) of the housing (2) by means of a respective connecting wall (11) for each section.

8. Device according to claim 7, **characterised in that** the connecting wall (11) is formed to be circular for each section.

## Revendications

1. Dispositif (1) destiné à recevoir au moins un composant (8) électrique ou électronique présentant un châssis (2), ledit au moins un composant (8) étant dispose dans l'intérieur, rempli d'un matériau de remplissage (3), ledit châssis (2) étant pourvu à l'intérieur d'au moins une partie en saillie (4) périphérique, présentant une contre-dépouille, **caractérisé en ce qu'**une fente (13) périphérique ou un espace intermédiaire (5) périphérique en forme de fente est forme entre le côté intérieur d'une paroi extérieure (10) périphérique et ladite au moins une partie en saillie (4) périphérique du châssis (2) et **en ce que** le matériau de remplissage est constitue par un adhésif thermofusible.

2. Dispositif selon la revendication 1, **caractérisé en ce que** la partie en saillie (4) est disposée dans la partie centrale du châssis (2).

3. Dispositif selon la revendication 1 ou 2, **caractérisé en ce que** le matériau de remplissage (3) est constitue d'adhésif thermofusible à base de polyamide.

4. Dispositif selon l'une quelconque des revendications précédentes, **caractérisé en ce que** le châssis (2) présente, au niveau de la partie en saillie (4) au moins un trou de moulage par injection (7) pour le matériau de remplissage.

5. Dispositif selon l'une quelconque des revendications précédentes, **caractérisé en ce que** la partie en saillie (4) est reliée sur sa périphérie en continu au moyen d'une paroi de liaison (9) en forme d'âme à la paroi extérieure (10) du châssis (2).

6. Dispositif selon la revendication 5, **caractérisé en ce que** la partie en saillie (4) et la paroi de liaison (9) sont réalisées ensemble avec une section en forme de T.

7. Dispositif selon l'une quelconque des revendications 1 à 4, **caractérisé en ce que** la partie en saillie (4) est reliée en sa périphérie par sections au moyen à chaque fois d'une paroi de liaison (11) à la paroi extérieure (10) du châssis (2).

8. Dispositif selon la revendication 7, **caractérisé en ce que** la paroi de liaison (11) est formée par sections à chaque fois en forme de cercle.
